# EUROPEAN PATENT APPLICATION

(11) **EP 1 104 937 A1**
(43) Date of publication of application: **06.06.2001**
(21) Application number: 00125008.3
(22) Date of filing: 16.11.2000
(51) Int. Cl.: H01L 27/00, H01L 51/20, B41J 2/45

(54) **Organic light emission element array on semiconductor substrate**

(30) Priority: 26.11.1999 JP 33564899
(71) Applicant: Taiyo Yuden Co., Ltd., Tokyo 110-0005 (JP)
(72) Inventor: Masaki, Yuichi, c/o Taiyo Yuden Co., Ltd., Tokyo 110-0005 (JP); Iida, Hideyo, c/o Taiyo Yuden Co., Ltd., Tokyo 110-0005 (JP); Kizawa, Masashi, c/o Taiyo Yuden Co., Ltd., Tokyo 110-0005 (JP)
(74) Representative: Goddar, Heinz J., Dr.

(57) **Abstract**

An organic light emission element array comprises: an organic light emission film (4); an array-like lower electrode (3), being connected to the organic light emission film (4); an upper electrode (5), being connected so as to put the organic light emission film (4) between the lower electrode (3); and an integrated circuit (2) for driving for applying voltage to the organic light emission film (4) so as to emit light therefrom. Herein, on the semiconductor substrate (1) is constructed the integrated circuit for driving (2), and on the semiconductor substrate (1) are formed the lower electrode (3), the organic light emission film (4) and the upper electrode (5), under condition of being laminated one by one.

## Description

### BACKGROUND OF THE INVENTION

### FIELD OF THE INVENTION

The present invention relates to a light emission element array for use as a light source of such as a printing head, etc., in electrophotography printers, and in particular it relates to an organic light emission element array with using organic electro-luminescence in a light emission film thereof.

### DESCRIPTION OF PRIOR ART

Conventionally, an LED printing head using an LED(s) therein has been used as the printing head, being as a light source of electrophotography printers. On the other hand, an organic light emission element array using the electro-luminescence therein comes to be proposed and/or devised as an organic electro-luminescent printing head. The organic light emission element array using the organic electro-luminescent printing head is simple in the manufacturing process thereof, in comparison with the LED array, therefore it is effective for reduction of the cost thereof.

In the organic light emission array using the above-mentioned organic light emission film, a plurality of chips of the organic light emission element array are disposed on a substrate along a line, and those organic light emission array chips are connected to a plurality of circuits of driver integrated circuits for driving, respectively, thereby constructing the printing head being aligned on a straight line. With such the printing head, the organic light emission elements of the printing head emit lights responding to drive signals which are generated from the driver integrated circuits for driving, and the lights emitted pass through a convergent rod lens array, so as to be irradiated upon a surface of a charged photoconductor drum, thereby forming an electrostatic image or picture.

In such the organic light emission element array as mentioned in the above, which is used as the printing head in the conventional art, since the plurality of the organic light emission elements and the plurality of the driver integrated circuits for driving are mounted on a circuit board, and further since they are connected to through wire bonding, there is a necessity that they must be treated with troublesome processes, such as mounting of the elements and the wire bonding thereof, therefore the manufacturing process comes to be complicated and takes costs for the manufacturing thereof. Also, on the circuit board are mounted those organic light emission elements and the respective driver integrated circuits for driving thereof, therefore there is a problem that it is difficult to make it small in the sizes thereof.

### SUMMARY OF THE INVENTION

An object is, according to the present invention, by taking such the problem in the conventional organic light emission element array into the consideration, to provide an organic light emission element array, with which can be constructed a printing head being small-sized and cheap.

According to the present invention, for accomplishing the above-mentioned object, an integrated circuit 2 for driving is constructed directly on a semiconductor substrate 1, on which are laminated an array-like lower electrode 3, an organic light emission film 4 and an upper electrode 5. With this, it is possible to construct the organic light emission element array, without mounting the organic light emission elements and the integrated circuit elements for driving thereof on a circuit board, thereby to connect them through the wire bonding, respectively.

Namely, according to the present invention, there is provided an organic light emission element array, comprising: an organic light emission film 4; an array-like lower electrode 3, being connected to said organic light emission film 4; an upper electrode 5, being connected so as to put said organic light emission film 4 between said lower electrode 3; and an integrated circuit 2 for driving for applying voltage to said organic light emission film 4 so as to emit light therefrom. Herein, on the semiconductor substrate 1 is constructed said integrated circuit 2 for driving, and on said semiconductor substrate 1 are formed said lower electrode 3, said organic light emission film 4 and said upper electrode 5, under condition of being laminated one by one.

With such the organic light emission element array, since the integrated circuit 2 for driving is constructed directly on the semiconductor substrate 1, and further on which are laminated the array-like lower electrode 3, the organic light emission film 4 and the upper electrode 5, therefore it can be manufactured only through a processing process for the semiconductor substrate 1 of constructing the integrated circuit 2 for driving thereon, and film forming process for forming the lower electrode 3, the organic light emission film 4 and the upper electrode 5 on the semiconductor substrate 1. Accordingly, there is no necessity that the organic light emission elements and the integrated circuit elements for driving are mounted on the circuit board respectively, nor is necessity of connecting the elements which are mounted through the bonding wire, etc.

The organic light emission film 4 and the integrated circuit 2 for driving thereof may be located at the positions, being separated on the semiconductor substrate 1, under the condition of being connected to each other through the lower electrode 3, however it is preferable to form the organic light emission film 4 on the integrated circuit 2 for driving through the lower electrode 3, thereby forming the integrated circuit 2 for driving and the organic light emission film 4 at the same position. With doing so, there is no useless plan remaining on the semiconductor substrate 1, thereby making the small-sizing of the organic light emission element array easier.

As was explained in the above, the organic light emission element array according to the present invention can be manufactured only through the processing process for the semiconductor substrate 1 of constructing the integrated circuit 2 for driving thereon, and the film forming process for forming the lower electrode 3, the organic light emission film 4 and the upper electrode 5 on the semiconductor substrate 1. According to this, there is no necessity of mounting the organic light emission elements and the integrated circuits for driving thereof on the circuit board, respectively, nor is necessity of the step of connecting the elements which are mounted on through the bonding wire. Therefore, it is possible to manufacture the organic light emission element array with the processes being simpler, as well as to make it easy in small-sizing thereof.

### BRIEF DESCRIPTION OF THE DRAWINGS

Fig. 1 is an outline plan view of an example of the organic light emission element array according to the present invention;
Fig. 2 is a view of A-A cross-section in the Fig. 1;
Fig. 3 is an outline plan view of another example of the organic light emission element array according to the present invention; and
Fig. 4 is a view of B-B cross-section in the Fig. 3.

### DESCRIPTION OF PREFERRED EMBODIMENTS

Hereinafter, embodiments according to the present invention will be fully explained in details thereof, by referring to the attached drawings.

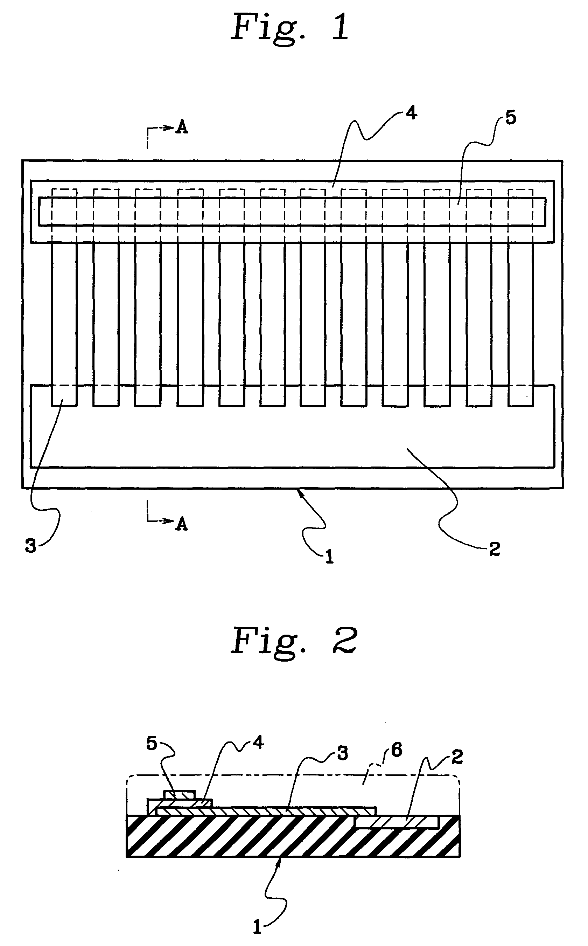

An example of the organic light emission element array according to the present invention will be shown in Figs. 1 and 2. A semiconductor substrate 1 is prepared, in advance, on which an integrated circuit 2 for driving is constructed. For example, transistors, diodes, resistors, capacitors, etc., are constructed or formed on a semiconductor wafer, such as silicon single crystal wafer, etc., by means of etching, doping, etc., thereby constructing the monolithic integrated circuit 2 for driving. Thereafter, the semiconductor wafer is divided into each substrate, so as to be the semiconductor substrate 1. Although not shown in the figure, on the integrated circuit 2 for driving are provided electrodes at a predetermined distance between them, for the purpose of outputting driving signals thereof.

Further beltlike conductor films or layers are provided, so that they pass through the electrodes for outputting the driving signals of the above-mentioned integrated circuit 2 for driving on the semiconductor substrate 1, thereby forming a plural number of lower electrodes 3. For example, those lower electrodes 3 are provided by forming a conductor film or layer under the condition of being masked on the portions other than those where the lower electrodes 3 are formed on the surface of the semiconductor substrate 1, through the sputtering method and/or the vacuum evaporation method. Or alternatively, after forming the conductive film or layer on the semiconductor substrate 1, the lower electrodes are formed by means of the photo etching, etc. The lower electrodes 3 shown in the figure are provided in parallel at a predetermined distance therebetween in the beltlike shape, and an end of the lower electrode 3 is located on the electrode for outputting driving signals of the above-mentioned integrated circuit 2 for driving, thereby being connected therewith.

At the other end of the lower electrode 3 is formed a longitudinal organic light emission film or layer 4, covering in a direction of disposition of those lower electrodes 3. This organic light emission film or layer 4 is a film body which is formed from an organic electro-luminescent material, and it is formed through the vacuum evaporation of the organic electro-luminescent material under the condition of being masked on the semiconductor substrate 1 in advance, or through etching by means of the photolithography after the vacuum evaporation of the organic electro-luminescent material on the semiconductor substrate 1, thereby forming the organic light emission film or layer, in such a pattern as shown in the Fig. 1.

The organic light emission film or layer may be of type of two (2) layers or three (3) layers. As the two (2) layer type, there are one in which an upper layer forms a hole transmission layer while a lower layer forms a light emission and an electron transmission layer, and other one in which the upper layer forms the light emission layer and the hole transmission layer while the lower layer forms the electron transmission layer. Also, in the three (3) layer type, an upper layer forms the hole transmission layer, a middle layer forms the light emission layer, and a lower layer forms the electron transmission layer.

As the organic electro-luminescent materials for forming the organic light emission layer 4, there are aluminum quinolinol complex (Alq3), oxadiazoles, etc., for the electron transmission layer, triphenylamines, polyvinyl carbazole, etc., for the hole transmission layer. Also, for the light emission layer, there are triphenyldiamine, perylenes, thiazoles, and stilbenzenes, etc.

Further, on this organic light emission layer 4, a transparent conductive layer of such as ITO film is formed through the vacuum evaporation method or the sputtering method, thereby forming the upper electrode 5. Such the upper electrode 5 as shown in the Fig. 1 is formed, for example, through forming the transparent conductive film of the ITO film, etc., on the semiconductor substrate 1, under the condition of being masked thereon in advance, or through etching the transparent conductive film of the ITO film, etc., by means of the photolithography, after forming it on the semiconductor substrate 1.

In the organic light emission element array mentioned above, by applying a signal voltage for driving from the integrated circuit 2 for driving, between the lower electrode 3 and the upper electrode in arbitrary, the organic light emission film emits the light from that portion. For example, in the printing head mentioned in the above, the light emitted from the above-mentioned organic light emission film 4, passing through the convergent rod lens array, irradiates on the surface of the charged photoconductor drum, thereby forming the electrostatic image or picture thereon.

Further, for the purpose of protection thereof, such the organic light emission element array of the semiconductor substrate 1 is covered with a transparent protection layer 6, at the both sides thereof, where the above-mentioned organic light emission arrays are formed.

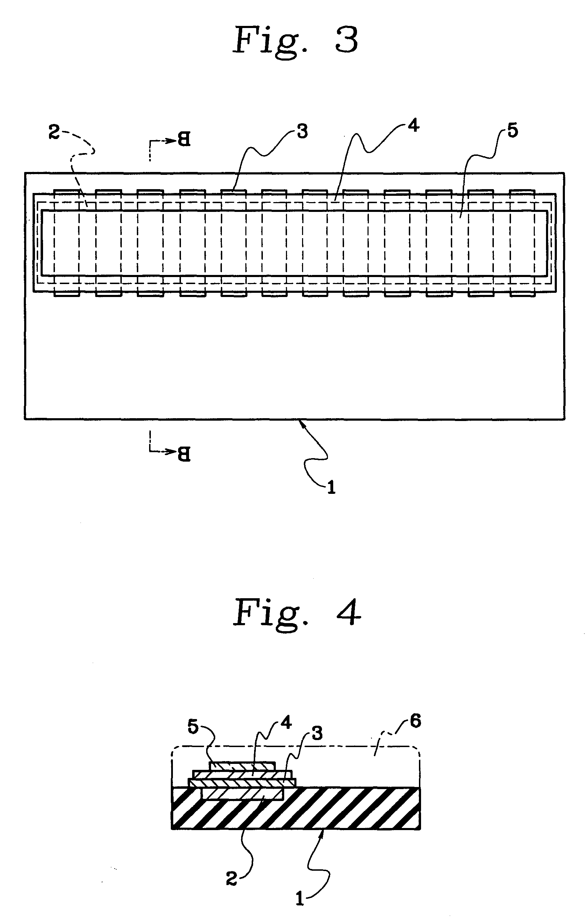

Figs. 3 and 4 show another example of the organic light emission element array according to the present invention. In the example of the organic light emission element array mentioned above, on the semiconductor substrate 1 on which the integrated circuit 2 for driving in advance, there is provided a longitudinal beltlike conductor film is provided, so as to from the lower electrode 3 therewith, and an end of this lower electrode 3 is connected to the electrode for outputting the driving signal of the above-mentioned integrated circuit 2 for driving, while forming the organic light emission film 4 and the upper electrode 5 at the other end of the lower electrode 3. Namely, the integrated circuit 2 for driving and the organic light emission film 4 are separated by the semiconductor substrate 1 therebetween.

On the contrary to this, in the example shown in the Figs. 3 and 4, on the integrated circuit 2 for driving are laminated the lower electrode 3, the organic light emission film 4 and the upper electrode 4 one by one, therefore the integrated circuit 2 for driving and the organic light emission film 4 are provided at the same position of the semiconductor substrate 1. The structures other than that mentioned in the above are basically same to those of the organic light emission element array, which was explained by referring to the Figs. 1 and 2.

With such the organic light emission element array as mentioned in those Figs. 3 and 4, since the integrated circuit 2 for driving and the organic light emission film 4 are provided at the same position of the semiconductor substrate 1, therefore it is possible to obtain further small-sizing of the organic light emission element array.

The features disclosed in the foregoing description, in the claims and/or in the accompanying drawings may, both separately and in any combination thereof, be material for realising the invention in diverse forms thereof.

## Claims

1. An organic light emission element array, comprising:
an organic light emission film (4);
an array-like lower electrode (3), being connected to said organic light emission film (4);
an upper electrode (5), being connected so as to put said organic light emission film (4) between said lower electrode (3); and
an integrated circuit (2) for driving for applying voltage to said organic light emission film (4) so as to emit light therefrom, wherein on the semiconductor substrate (1) is constructed said integrated circuit for driving (2), and on said semiconductor substrate (1) are formed said lower electrode (3), said organic light emission film (4) and said upper electrode (5), under condition of being laminated one by one.

2. An organic light emission element array as defined in the claim 1, wherein said organic light emission film (4) and said integrated circuit (2) for driving are located on said semiconductor substrate (1), under condition of being connected with said lower electrode (3), at positions being separated from each other.

3. An organic light emission element array as defined in the claim 1, wherein said organic light emission film (4) is formed on said integrated circuit (2) for driving through said lower electrode (3).
